# FASCICULE DE BREVET EUROPEEN

(11) **EP 0 871 284 B1**
(45) Date de publication et mention de la délivrance du brevet: **14.09.2005**
(21) Numéro de dépôt: 98106049.4
(22) Date de dépôt: 02.04.1998
(51) Int. Cl.: H02K 41/02, H02K 41/035

(54) **Table X-Y pour déplacer des charges avec une haute précision et une très grande dynamique**
X-Y Kreuztisch zur Verstellung von Lasten mit hoher Genauigkeit und sehr hoher Dynamik
X-Y Table to move loads with high precision and very high dynamic

(30) Priorité: 11.04.1997 EP 97105995
(43) Date de publication de la demande: 14.10.1998
(73) Titulaire: Etel S.A., 2112 Môtiers (CH)
(72) Inventeur: Wavre, Nicolas, 2000 Neuchâtel (CH)
(74) Mandataire: Balsters, Robert

(56) Documents cités:
- EP-A- 0 317 787
- CH-A- 678 907
- DE-A- 3 037 648
- US-A- 5 196 745
- US-A- 5 334 892
- PATENT ABSTRACTS OF JAPAN vol. 018, no. 366 (M-1636), 11 juillet 1994 & JP 06 099327 A (YASKAWA ELECTRIC CORP), 12 avril 1994
- PATENT ABSTRACTS OF JAPAN vol. 096, no. 002, 29 février 1996 & JP 07 276166 A (KAIJO CORP), 24 octobre 1995

## Description

La présente invention est relative aux tables X-Y destinées à assurer les déplacements de charges diverses selon deux axes perpendiculaires.

Plus particulièrement, l'invention concerne de telles tables X-Y utilisées pour déplacer des charges avec une très grande dynamique de mouvement et une haute précision, exigences qui sont souvent imposées à des machines conçues pour effectuer des opérations de fabrication sur des objets de faibles, voire très faibles dimensions comme les circuits intégrés par exemple. Dans ce domaine en particulier, on demande aux tables X-Y une précision de positionnement d'un micromètre ou moins, une vitesse de déplacement sur chaque axe de plusieurs m/s et une grande rigidité aussi bien statique que dynamique.

Une application d'une table X-Y selon l'invention à laquelle celle-ci n'est évidemment nullement limitée, est celle des machines de soudage des fils de connexion aux circuits intégrés (opération que l'on désigne souvent par l'expression anglaise de "bonding").

Une telle table est décrite dans le brevet suisse CH 678 907. Elle comporte une embase sur laquelle est fixée une plaque de glissement. Sur cette plaque peut coulisser avec un frottement très réduit un chariot qui supporte la charge et auquel sont associés des moyens de guidage qui astreignent le chariot à se déplacer selon deux directions perpendiculaires X et Y. Des moteurs électriques sont prévus pour animer le chariot. Ils sont conçus de telle manière que le moteur affecté à l'entraînement selon l'une des directions admet le déplacement du chariot selon l'autre direction. Les éléments mobiles des moteurs sont couplés directement au chariot et leurs éléments fixes sont placés sur l'embase de la table.

Dans l'une des variantes de réalisation décrite dans ce document antérieur et présentée à la figure 3 de celui-ci, chaque moteur comporte une culasse magnétique formée de deux pièces ferromagnétiques placées l'une au-dessus de l'autre avec un certain intervalle entre elles. Cet intervalle constitue un entrefer dans lequel se déplace l'élément mobile du moteur, cet élément étant directement couplé au chariot. Une bobine est enroulée sur chaque pièce ferromagnétique. Les bobines coopèrent avec des aimants portés par l'élément mobile.

Si on considère dans cette construction le moteur ayant comme direction active la direction X par exemple, les pièces ferromagnétiques et l'entrefer ont, dans la direction non active Y de ce moteur, une étendue inférieure à la dimension dans cette même direction de l'élément mobile. Cet agencement permet ainsi le déplacement selon la direction Y de l'élément mobile destiné à la direction active X.

Par ailleurs, l'axe d'enroulement des bobines dans ce même moteur est orienté dans la direction X de sorte que le flux magnétique trace une boucle virtuelle dont le plan général est parallèle à la direction X et dont l'axe central s'étend dans la direction Y.

On ne peut concevoir cette construction connue qu'avec quatre pôles statoriques, c'est-à-dire deux par pièce ferromagnétique, ce qui a pour conséquence une course limitée de l'élément mobile selon sa propre direction active. Comme chaque moteur est affecté de ce même défaut, les courses du chariot dans les deux directions sont limitées dans la même mesure.

Cette construction des moteurs de la table présente un autre inconvénient grave consistant en ce que dans chaque moteur l'ouverture traversante définie par l'entrefer dans lequel est situé l'élément mobile est orientée perpendiculairement à la direction active de ce moteur de sorte que la force de traction qu'il exerce sur le chariot présente un bras de levier engendrant un moment de force sur ce chariot dans le plan des directions actives au détriment d'une bonne dynamique des mouvements, car ce moment de force tend à faire tourner le chariot autour d'un axe perpendiculaire à ce plan.

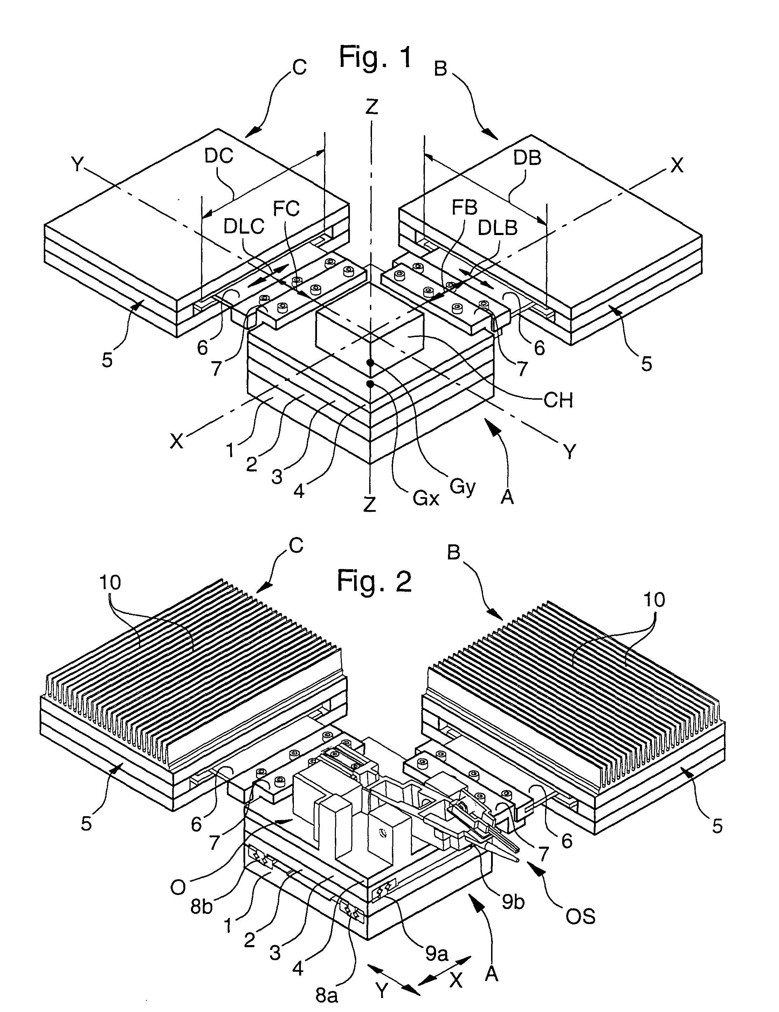

On connaît également du document DE 3037148 une table X-Y formée d'au moins deux moteurs linéaires. Dans différents modes de réalisation particuliers, chaque moteur linéaire est formé d'une part par une seule bobine d'excitation et d'autre part par deux aimants permanents alignés selon la direction active du moteur considéré avec une polarité inversée l'un par rapport à l'autre. Dans tous ces modes de réalisations particuliers (voir figures 1 à 9 et 15 à 17), la dimension des aimants permanents, selon la direction perpendiculaire à la direction active d'un moteur considéré dans le plan de déplacement de la partie mobile de la table, est largement inférieure à la dimension correspondante de la bobine associée à l'élément mobile de ce moteur considéré.

Les modes de réalisations proposés avec une bobine fixe associées à une armature magnétique du stator et deux aimants permanents associés à l'éléments mobile sont très désavantageux et s'avèrent être de construction très délicate. En effet, les aimants permanents étant attirés par ladite armature magnétique doivent être maintenus dans une position milieu définissant un équilibre instable. Dès que les aimants sont situés hors de cette position milieu, ils sont fortement attirés par l'armature magnétique; ce qui crée des instabilités et diminue fortement l'efficacité du moteur linéaire.

Toutes les variantes de réalisation d'une table X-Y avec aimants permanents fixes décrits dans le document DE 3037648 présentent les mêmes inconvénients que ceux mentionnés pour la table X-Y décrite dans le document CH 678907. En effet, en considérant par exemple la table X-Y décrite aux figures 1 et 2 de ce document allemand, on constate que la force résultante exercée par un moteur linéaire sur la partie mobile varie relativement au centre de gravité de cette partie mobile en fonction de la position relative de la bobine associée à l'élément mobile de ce moteur avec les aimants permanents du stator de ce moteur linéaire. Ensuite, la structure monophasée avec une bobine et deux aimants permanents de polarité inversée limite la course à de petits déplacements.

Le fait que la force résultante exercée par un moteur linéaire sur la partie mobile varie relativement au centre de gravité de cette partie mobile lorsque cette dernière est entraînée par un autre moteur linéaire selon la direction perpendiculaire à la direction active du moteur linéaire considéré résulte du fait que seule la section de la bobine superposée aux aimants permanents est active. En d'autres termes, la force résultante d'un moteur linéaire définit une droite sensiblement fixe relativement au stator de la table X-Y. Ainsi, des moments de force (couples) variables provoquant des instabilités de la partie mobile sont engendrées lors du fonctionnement de la table X-Y décrite dans le document allemand susmentionné.

Le document US 4,788,477 décrit une table X-Y avec des moteurs réluctants. Cette table comprend un stator commun aux deux moteurs, formé par une matrice de plots ou de trous définissant un profil en créneau selon les deux directions X et Y. Ce stator s'étend sous le chariot mobile. Les éléments mobiles des deux moteurs sont agencés sous le chariot. La table X-Y comprend en outre des moyens de coulissement selon les deux directions X et Y qui sont agencés à la périphérie du bloc central comprenant le chariot et les deux moteurs.

L'invention a pour but de fournir une table X-Y à grande dynamique dans laquelle les inconvénients des tables de l'art antérieur citées ci-dessus sont éliminés.

A cet effet, l'invention a pour objet une table X-Y associée à une charge, telle qu'un outil, et agencée pour déplacer cette charge selon deux directions actives et perpendiculaires (X et Y), cette table comprenant :
- une embase,
- un chariot supportant ladite charge et monté mobile sur l'embase selon lesdites deux directions, et
- deux moteurs électriques linéaires agencés pour entraîner ledit chariot respectivement selon lesdites deux directions actives, chacun de ces deux moteurs comprenant un stator et un élément mobile pourvu d'au moins une bobine d'excitation et couplé mécaniquement audit chariot, ledit élément mobile étant susceptible d'être déplacé selon chacune des deux directions actives, ledit chariot mobile étant guidé selon lesdites deux directions actives respectivement par des premiers et seconds moyens de coulissement, un premier des deux moteurs déplaçant selon sa direction active une première masse mobile et le second de ces deux moteurs déplaçant selon sa direction active une deuxième masse mobile comprenant ladite première masse mobile, caractérisée en ce que ladite première masse mobile comprend ladite charge, ledit chariot et lesdits éléments mobiles des deux moteurs, cette première masse mobile formant une unité solidaire, en ce que la force résultante exercée par ledit premier moteur définit une première droite qui coupe sensiblement une droite verticale passant par le centre de gravité de ladite première masse mobile, cette première droite ayant une position fixe relativement à ladite première masse mobile, en ce que la force résultante exercée par ledit second moteur définit une deuxième droite qui coupe sensiblement une droite verticale passant par le centre de gravité de ladite deuxième masse mobile lorsque ledit chariot se trouve dans une position centrale de la table X-Y selon la direction active dudit premier moteur, en ce que lesdits deux moteurs linéaires sont agencés à la périphérie d'une unité principale formée par ledit chariot portant ladite charge et lesdits premiers et seconds moyens de coulissement en laissant libre au moins un côté dudit chariot, et en ce que chacun des deux moteurs linéaires a une pluralité d'aimants permanents juxtaposés de polarités nord et sud alternées selon la direction active de ce moteur, ladite au moins une bobine d'excitation d'un quelconque des deux moteurs ayant, selon la direction active de l'autre de ces deux moteurs, une dimension inférieure à la dimension correspondante desdits aimants permanents de ce moteur, la différence entre ces deux dimensions étant sensiblement égale ou supérieure à la course de l'élément mobile du moteur considéré selon la direction active de l'autre de ces deux moteurs.

Grâce à ces caractéristiques, la table X-Y selon l'invention présente une grande stabilité en fonctionnement par le fait que les moments de force dans le plan X-Y de la partie mobile de cette table sont réduits au minimum et même annulés selon la direction active dudit premier moteur, les moyens de coulissement assurant que la table ne subisse pas de rotation dans le plan X-Y. Ainsi, la table X-Y selon la présente invention peut fonctionner avec une grande dynamique sans vibration et sans nécessiter d'asservissement électronique pour assurer des déplacements linéaires selon les axes X et Y.

La présente invention sera décrite plus en détail à l'aide de la description qui suit, donnée uniquement à titre d'exemple et faite en se référant aux dessins annexés sur lesquels:
- la figure 1 est une vue en perspective schématique d'une table X-Y selon l'invention;
- la figure 2 est une vue en perspective plus détaillée de cette table montrant notamment un exemple d'une charge pouvant être animée par la table, ici un outil de soudage destiné à effectuer des opérations de "bonding";
- la figure 3 est une vue en plan de la table X-Y représentée sur la figure 2;
- la figure 4 est une vue en perspective, à plus grande échelle, de l'un des moteurs linéaires utilisés dans la table X-Y selon l'invention;
- la figure 5 montre une vue en perspective du stator démonté de l'un des moteurs linéaires;
- la figure 6 est une vue en plan schématique montrant l'élément mobile de l'un des moteurs linéaires de la table X-Y selon l'invention, pour illustrer plus particulièrement l'agencement des bobines;
- la figure 7 montre par une vue schématique en plan une variante de la table X-Y selon l'invention.

On va tout d'abord se référer à la figure 1 pour expliquer le principe de fonctionnement d'une table X-Y selon l'invention.

La table X-Y comprend trois unités principales, à savoir une unité mobile A dans un plan X-Y, un premier moteur linéaire B assurant l'entraînement selon la direction active X et un second moteur linéaire C assurant l'entraînement selon la direction active Y, perpendiculairement à la direction X, les moteurs linéaires B et C étant de construction identique. On entend par "direction active", celle dans laquelle s'exerce la force de traction ou de poussée du moteur linéaire considéré.

L'unité mobile A comprend une embase 1 reposant sur un plan de travail quelconque (non représenté), cette embase ayant dans l'exemple décrit une forme sensiblement rectangulaire. Sur cette embase peut coulisser selon la direction X et par l'intermédiaire de moyens de coulissement appropriés (non représentés sur la figure 1) un premier plateau 2. Sur ce premier plateau peut coulisser selon la direction Y et par l'intermédiaire de seconds moyens de coulissement appropriés (également non représentés) un second plateau 3 qui est solidaire d'un chariot 4 destiné à supporter une charge CH (représentée symboliquement à la figure 1). On notera que les plateaux 2 et 3 et leurs moyens de coulissement associés forment ensemble des moyens support mobiles du chariot 4 permettant à celui-ci de se déplacer avec un frottement minimal dans les deux directions X et Y.

Les moteurs linéaires B et C comprennent chacun un stator 5 et un élément mobile 6, ce dernier étant rigidement solidaire du chariot 4 par l'intermédiaire d'une pièce de connexion 7 et à l'aide de moyens de fixation appropriés connus de l'homme du métier.

Dans le mode de réalisation décrit à titre d'exemple en référence aux figures 1 à 6, on distingue des première et deuxième masses mobiles respectivement selon les deux directions actives X et Y. Ces première et deuxième masses mobiles comprennent chacune le chariot 4 et le plateau 3, la première masse mobile entraînée selon l'axe X comprenant le plateau 2 en plus de la deuxième masse mobile. Ces première et deuxième masses ont respectivement des centres de gravité GX et GY. Selon l'invention, les forces motrices résultantes FB et FC engendrées respectivement par les moteurs linéaires B et C définissent respectivement des première et deuxième droites perpendiculaires et fixes relativement au chariot 4, quelle que soit la position de celui-ci. L'agencement conduisant à cette caractéristique de l'invention sera décrit plus en détails par la suite. On notera de suite que ladite deuxième droite parallèle à la direction active Y et définie par la force résultante engendrée par le moteur C coupent sensiblement la droite verticale passant par le centre de gravité GY défini ci-avant. De préférence, ladite première droite coupe sensiblement la droite verticale passant par le centre de gravité GX de ladite première masse mobile lorsque le chariot 4 se trouve dans une position centrale de la table selon la direction X.

La figure 1, donnant une représentation schématique de la table X-Y selon l'invention, présente la particularité d'avoir les deux centres de gravité GX et GY alignés sur une même droite verticale Z lorsque les plateaux 2 et 3 sont superposés l'un à l'autre. On remarquera que cette situation est particulière étant donné que les première et deuxième masses mobiles comprennent chacune les deux éléments mobiles 6 associés respectivement aux deux moteurs linéaires représentés. Cette situation particulière résulte donc d'un positionnement spécifique de la charge CH sur le chariot 4.

L'agencement de la table X-Y selon l'invention, en particulier l'agencement des moteurs linéaires prévus, permet donc l'application de forces de poussée constantes sur la partie mobile de la table- En agençant correctement les éléments mobiles des moteurs linéaires relativement au chariot 4 et à la charge installée sur ce chariot, la force résultante exercée par chaque moteur linéaire sur la partie mobile de la table est appliquée en direction du centre de gravité de cette partie mobile. Plus précisément, il est prévu que les droites définies par les forces résultantes des deux moteurs linéaires coupent sensiblement une droite verticale passant par le centre de gravité de la partie mobile (cas où les masses déplacées selon les deux axes X et Y sont identiques).

Dans une variante préférée, il est prévu d'agencer les éléments mobiles des moteurs dans une position verticale relativement à la partie mobile pour que lesdites droites définies par les forces résultantes de ces moteurs se coupent sensiblement au centre de gravité de cette partie mobile. Dans ce dernier cas, la table X-Y est particulièrement stable et permet de déplacer la partie mobile avec une haute précision et une très grande dynamique.

Chacun des moteurs B et C présente un degré de liberté selon sa propre direction active X ou Y et également un degré de liberté supplémentaire, DLB et DLC, respectivement, selon la direction active de l'autre moteur. Ce degré de liberté supplémentaire est toutefois limité à une certaine distance indiquée respectivement par DB et DC sur la figure 1 et déterminée par construction des moteurs B et C. Dans l'exemple représenté, les distances DB et DC sont égales, mais ceci n'est pas une condition obligatoire.

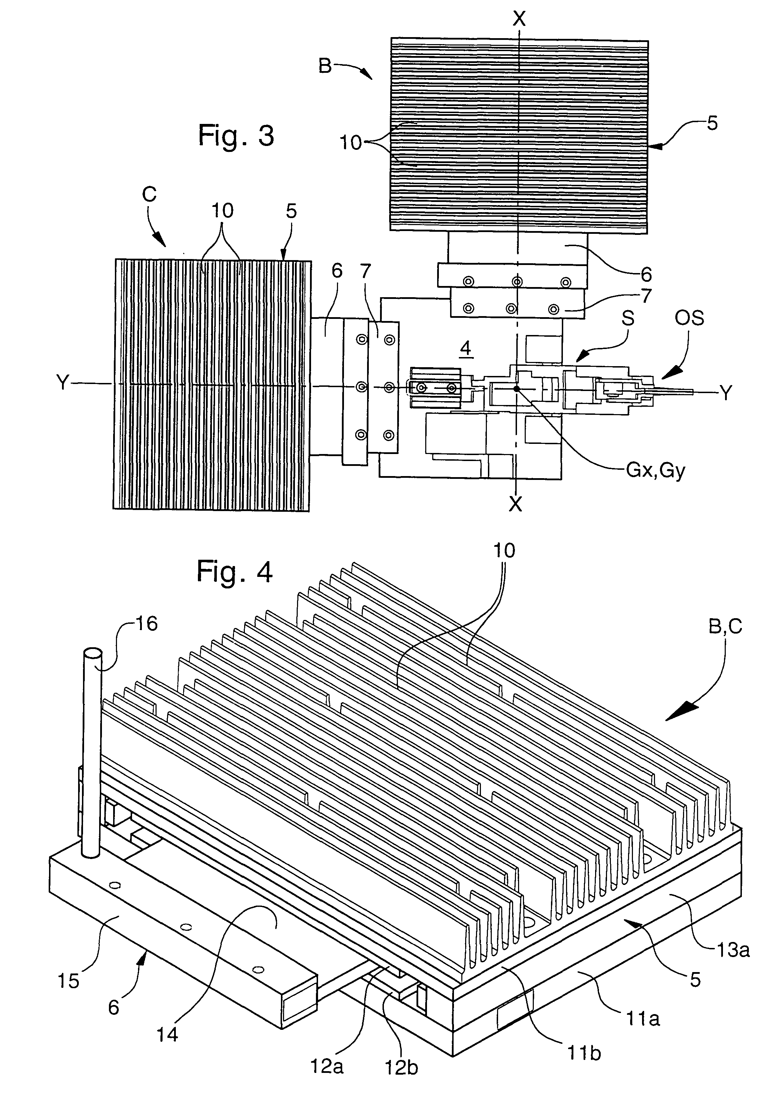

Les figures 2 et 3 montrent une table X-Y conforme à l'invention selon un mode de réalisation correspondant à celui représenté schématiquement à la figure 1. La figure 2 illustre une forme possible des moyens de coulissement interposés entre l'embase 1 et le premier plateau 2, d'une part, et ce premier plateau 2 et le deuxième plateau 3, d'autre part. Ces moyens de coulissement sont formés par des roulements linéaires respectifs 8a-8b et 9a-9b.

Par ailleurs, chaque moteur B et C présente des ailettes de refroidissement 10.

A titre d'exemple, le chariot 4 porte une charge formée par une unité de soudage O, connue en soi et présentant notamment un outil de soudage OS apte à exécuter des soudures notamment sur des bornes de circuits intégrés (opération de "bonding"). Cette unité de soudage S ne faisant pas partie de l'invention, elle ne sera pas décrite en détail.

Bien entendu, de façon également connue en soi, la table X-Y peut être équipée de capteurs de position (non représentés) pour détecter en permanence les positions en X et Y du chariot 4 et élaborer des signaux de position utilisables par des moyens électroniques commandant les mouvements du chariot 4 en fonction de signaux de consigne.

Les figures 4 à 6 représentent une construction selon l'invention de chacun des moteurs linéaires B et C.

L'élément statorique 5 comprend deux plaques 11a et 11b de forme sensiblement rectangulaire et réalisées en une matière ferromagnétique appropriée. Chacune des deux plaques est équipée d'une série d'aimants 12a et 12b juxtaposés de polarité nord et sud alternées, les pôles N des aimants 12a de l'une des plaques se trouvant en face des pôles S des aimants 12b de l'autre plaque, et inversement. Les plaques 11a et 11b sont maintenues à une distance bien déterminée l'une de l'autre par l'intermédiaire de pièces d'entretoise 13a et 13b déterminant en même temps deux entrefers du moteur. Les axes d'aimantation de tous les aimants 12a et 12b de chaque moteur sont parallèles entre eux et perpendiculaires au plan défini par les directions actives X et Y.

Selon l'invention, la longueur DB ou DC des aimants 12a et 12b est supérieure à la longueur L des bobines 20 et 21, ces longueurs étant orientées perpendiculairement à la direction active du moteur considéré dans le plan de déplacement X-Y de l'élément mobile de ce moteur. De plus, la différence entre la longueur DB ou DC et la longueur L des bobines est sensiblement égale ou supérieure à la course de l'élément mobile d'un moteur considéré selon la direction active de l'autre des deux moteurs B et C.

L'élément mobile 6 de chaque moteur linéaire B ou C comprend une plaque 14 (figures 2, 4 et 6) de forme sensiblement rectangulaire et d'une largeur inférieure à l'écartement des entretoises 13a et 13b pour autoriser le second degré de liberté du moteur considéré.

Un étrier 15 est fixé rigidement sur le bord de la plaque 14. Cet étrier 15 sert de pièce de liaison de l'élément mobile 6 à la pièce de connexion 7 à laquelle il est fixé solidement par boulonnage, par exemple. L'étrier 15 est également destiné à la connexion électrique de la partie mobile 6 à un circuit d'alimentation et de commande extérieure (non représenté), par l'intermédiaire d'une gaine 16. Une construction sans étrier est également possible.

Deux groupes de bobines 17a et 17b sont disposés dans la plaque 14 par exemple en y étant incorporés par moulage dans une masse non magnétique. Ainsi, l'élément mobile 6 est essentiellement non magnétique. La plaque 14 est réalisée en une matière à haute résistance mécanique et à haute conductibilité thermique, par exemple une matière plastique moulée renforcée par des fibres de carbone dans laquelle les groupes de bobines 17a et 17b sont incorporés par moulage. A titre de variante non illustrée sur les figures, on peut utiliser également pour refroidir le moteur, un refroidissement à air forcé ou à eau, intégré dans la plaque 14.

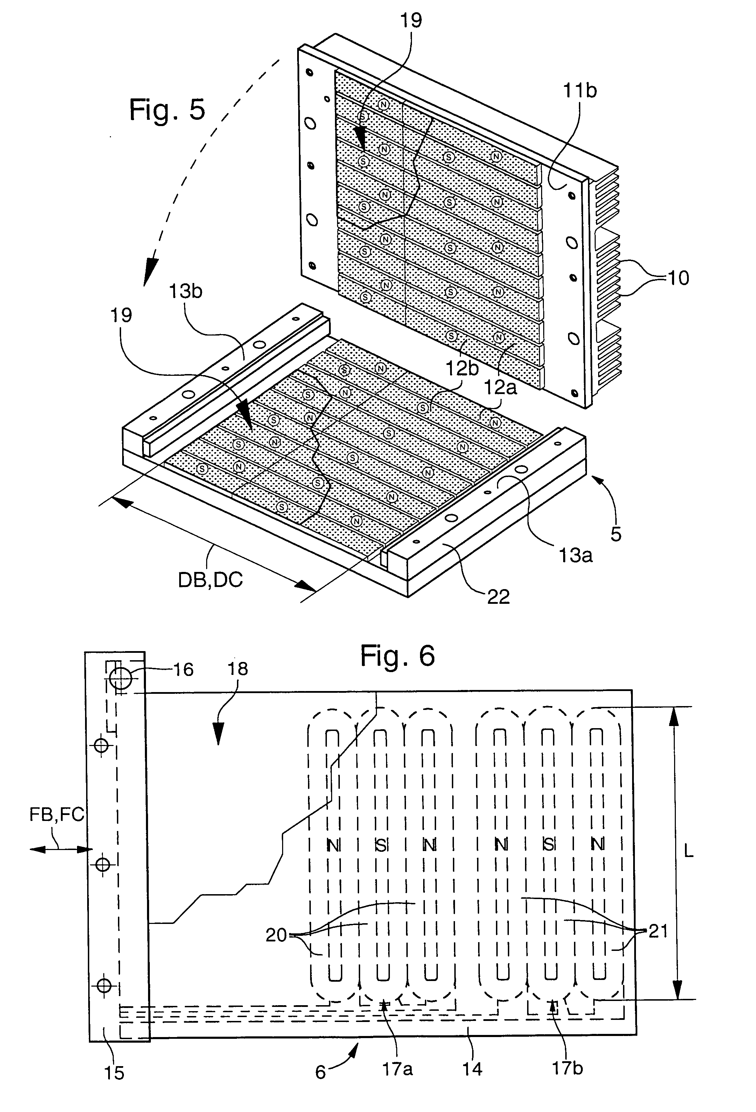

On peut augmenter la résistance à la flexion de la plaque 14 perpendiculairement à sa direction de déplacement, en la revêtant d'une couche 18 de texture superficielle lisse, uniforme et parfaitement plane, en un matériau rigide et non magnétique, comme l'époxy ou la céramique, matériau avec lequel peuvent également être couverts les aimants permanents 12a et 12b du stator 5 (couches 19, voir figure 5). Les aimants peuvent aussi être recouverts d'une plaque métallique conductrice (cuivre, fer ou aluminium) pour réduire la constante de temps électrique des bobines. De cette manière, il est possible de définir un jeu mécanique très faible dans les entrefers du moteur, jeu dans lequel la couche d'air pourra fonctionner comme amortisseur d'éventuelles vibrations. Cet agencement présente en outre l'avantage d'améliorer le transfert thermique entre les bobines et les aimants, ce qui permet d'augmenter la puissance efficace du moteur pour un dimensionnement donné de ses composants.

Dans l'exemple décrit, les groupes de bobines 17a et 17b sont agencés de telle manière que le moteur B ou C soit de type synchrone biphasé. Bien entendu, cet agencement n'est choisi qu'à titre d'exemple, tout agencement des bobines, par exemple en groupes ou en continu, mono ou triphasé étant également possible. Chaque groupe comporte trois bobines 20 et 21, respectivement, les deux groupes étant décalés d'une distance qui est, dans cet exemple, la moitié de la période spatiale définie par les bobines d'un même groupe. Chaque bobine 20 et 21 est enroulée à plat dans la plaque 14 selon un axe d'enroulement parallèle aux axes d'aimantation des aimants permanents du stator 5 qui présentent une période spatiale identique à celle susmentionnée. Les enroulements des bobines sont effectués de manière que lorsqu'elles sont parcourues par un courant, les bobines d'un même groupe engendrent alternativement des pôles N et S.

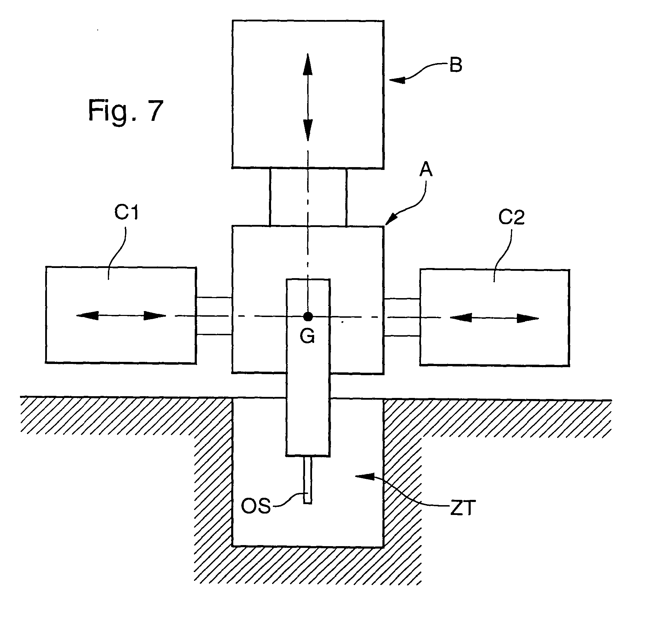

La figure 7 illustre une variante de la table X-Y selon l'invention dans laquelle le moteur linéaire C est divisé en deux unités motrices C1 et C2 ayant comme direction active la direction Y. L'utilisation de deux unités motrices pour la direction active Y permet de réduire leurs dimensions et d'obtenir ainsi le maximum de dégagement à gauche et à droite de la zone de travail ZT balayée par l'outil OS. De plus, la répartition de la force exercée par le moteur C de part et d'autre de la partie mobile de la table X-Y permet d'obtenir encore une meilleure stabilité de cette partie mobile en déplacement.

## Revendications

1. Table X-Y associée à une charge (CH;O,OS), telle qu'un outil, et agencée pour déplacer cette charge selon deux directions actives et perpendiculaires (X,Y), cette table comprenant :
- une embase (1),
- un chariot (4) supportant ladite charge (CH; O, OS) et monté mobile sur l'embase selon lesdites deux directions (X, Y); et
- deux moteurs électriques linéaires (B, C; B, C1, C2) agencés pour entraîner ledit chariot respectivement selon lesdites deux directions actives (X, Y), chacun de ces deux moteurs comprenant un stator (5) et un élément mobile (6) pourvu d'au moins une bobine d'excitation (20, 21) et couplé mécaniquement audit chariot, ledit élément mobile étant susceptible d'être déplacé selon chacune des deux directions actives (X, Y), ledit chariot mobile étant guidé selon lesdites deux directions actives respectivement par des premiers et seconds moyens de coulissement, un premier (C) des deux moteurs déplaçant selon sa direction active (Y) une première masse mobile et le second (B) de ces deux moteurs déplaçant selon sa direction active (X) une deuxième masse mobile comprenant ladite première masse mobile, **caractérisée en ce que** ladite première masse mobile comprend ladite charge, ledit chariot et lesdits éléments mobiles des deux moteurs, cette première masse mobile formant une unité solidaire, **en ce que** la force résultante exercée par ledit premier moteur définit une première droite qui coupe sensiblement une droite verticale passant par le centre de gravité (GY) de ladite première masse mobile, cette première droite ayant une position fixe relativement à ladite première masse mobile, **en ce que** la force résultante exercée par ledit second moteur définit une deuxième droite qui coupe sensiblement une droite verticale passant par le centre de gravité (GX) de ladite deuxième masse mobile lorsque ledit chariot se trouve dans une position centrale de la table X-Y selon la direction active dudit premier moteur, **en ce que** les deux moteurs linéaires sont agencés à la périphérie d'une unité principale, formée par ledit chariot portant ladite charge et lesdits premiers et seconds moyens de coulissement, en laissant libre au moins un côté dudit chariot, et **en ce que** chacun des deux moteurs linéaires a une pluralité d'aimants permanents (12a, 12b) juxtaposés de polarités nord et sud alternées selon la direction active de ce moteur, ladite au moins une bobine d'excitation d'un quelconque des deux moteurs ayant, selon la direction active de l'autre de ces deux moteurs, une dimension inférieure à la dimension correspondante desdits aimants permanents de ce moteur, la différence entre ces deux dimensions étant sensiblement égale ou supérieure à la course de l'élément mobile du moteur considéré selon la direction active de l'autre de ces deux moteurs.

2. Table X-Y selon la revendication 1, **caractérisée en ce que** ladite deuxième droite coupe sensiblement ladite droite verticale passant par le centre de gravité de ladite première masse mobile.

3. Table X-Y selon la revendication 1 ou 2, **caractérisée en ce que** les éléments mobiles respectifs desdits premier et deuxième moteurs sont agencés dans une position verticale relativement aux première et deuxième masses mobiles pour que lesdites première et deuxième droites définies par les forces résultantes respectives de ces premier et deuxième moteurs coupent sensiblement les centres de gravité desdites première et deuxième masses mobiles.

4. Table X-Y selon l'une des revendications précédentes, **caractérisée en ce que** ledit élément mobile de chacun des deux moteurs est formé essentiellement de matériaux non magnétiques.

5. Table X-Y selon l'une des revendications précédentes, **caractérisée en ce que** l'élément mobile de chacun des deux moteurs est pourvu de plusieurs bobines plates juxtaposées dont les axes d'enroulement sont perpendiculaires au plan défini par lesdites deux directions actives (X, Y).

6. Table X-Y selon l'une des revendications précédentes, **caractérisée en ce qu'**il est prévu pour chacun des deux.moteurs linéaires deux séries d'aimants permanents (12a, 12b) agencés de part et d'autre de l'élément mobile (6) de manière que chaque paire d'aimants permanents situés l'un en regard de l'autre définissent deux axes magnétiques de même sens.

7. Table X-Y selon l'une des revendications précédentes, **caractérisée en ce que** l'un des deux moteurs linéaires est formé par deux unités motrices distinctes (C1, C2) situées de part et d'autre du chariot mobile (4).

## Patentansprüche

1. X-Y-Tisch, der einer Beladung (CH; O, OS) wie etwa einem Werkzeug zugeordnet und so beschaffen ist, dass diese Beladung längs zweier aktiver und zueinander senkrechter Richtungen (X, Y) verlagerbar ist, wobei dieser Tisch umfasst:
- einen Sockel (1),
- einen Schlitten (4), der die Beladung (CH; O, OS) trägt und am Sockel längs der zwei Richtungen (X, Y) beweglich angebracht ist; und
- zwei Linearelektromotoren (B, C; B, C1, C2), die so beschaffen sind, dass sie den Schlitten längs der zwei aktiven Richtungen (X, Y) antreiben, wobei jeder dieser zwei Motoren einen Stator (5) und ein bewegliches Element (6) umfasst, das mit wenigstens einer Erregungsspule (20, 21) versehen und mit dem Schlitten mechanisch gekoppelt ist, wobei das bewegliche Element längs jeder der zwei aktiven Richtungen (X, Y) verlagert werden kann, wobei der bewegliche Schlitten längs der zwei aktiven Richtungen durch erste bzw. zweite Gleitmittel geführt wird, wobei ein erster (C) der zwei Motoren längs seiner aktiven Richtung (Y) eine erste bewegliche Masse verlagert und der zweite (B) dieser zwei Motoren längs dessen aktiver Richtung (X) eine zweite bewegliche Masse verlagert, die die erste bewegliche Masse umfasst, **dadurch gekennzeichnet, dass** die erste bewegliche Masse die Beladung, den Schlitten und die beweglichen Elemente der zwei Motoren umfasst, wobei diese erste bewegliche Masse eine feste Einheit bildet, dass die resultierende Kraft, die durch den ersten Motor ausgeübt wird, eine erste Gerade definiert, die eine vertikale Gerade, die durch den Schwerpunkt (GY) der ersten beweglichen Masse verläuft, im Wesentlichen schneidet, wobei diese erste Gerade eine feste Position in Bezug auf die erste bewegliche Masse hat, dass die resultierende Kraft, die durch den zweiten Motor ausgeübt wird, eine zweite Gerade definiert, die eine vertikale Gerade, die durch den Schwerpunkt (GX) der zweiten beweglichen Masse verläuft, wenn sich der Schlitten in einer Mittelposition des X-Y-Tisches in der aktiven Richtung des ersten Motors befindet, im Wesentlichen schneidet, dass die zwei Linearmotoren am Umfang einer Haupteinheit angeordnet sind, die durch den die Beladung tragenden Schlitten und die ersten und die zweiten Gleitmittel gebildet ist, wobei wenigstens eine Seite des Schlittens frei gelassen wird, und dass jeder der zwei Linearmotoren mehrere Permanentmagneten (12a, 12b) besitzt, die in der aktiven Richtung dieses Motors mit abwechselnder Nord- und Südpolarität nebeneinander angeordnet sind, wobei die wenigstens eine Erregungsspule irgendeines der zwei Motoren in der aktiven Richtung des anderen dieser zwei Motoren eine Abmessung besitzt, die kleiner als die entsprechende Abmessung der Permanentmagneten dieses Motors ist, wobei der Unterschied zwischen diesen zwei Abmessungen im Wesentlichen gleich oder größer als die Bahn des beweglichen Elements des betrachteten Motors in der aktiven Richtung des anderen dieser zwei Motoren ist.

2. X-Y-Tisch nach Anspruch 1, **dadurch gekennzeichnet, dass** die zweite Gerade die vertikale Gerade, die durch den Schwerpunkt der ersten beweglichen Masse verläuft, im Wesentlichen schneidet.

3. X-Y-Tisch nach Anspruch 1 oder 2, **dadurch gekennzeichnet, dass** die beweglichen Elemente des ersten bzw. des zweiten Motors in einer vertikalen Position in Bezug auf die erste und die zweite bewegliche Masse angeordnet sind, so dass die erste und die zweite Gerade, die durch die resultierenden Kräfte des ersten bzw. des zweiten Motors definiert sind, die Schwerpunkte der ersten bzw. der zweiten beweglichen Masse im Wesentlichen schneiden.

4. X-Y-Tisch nach einem der vorhergehenden Ansprüche, **dadurch gekennzeichnet, dass** das bewegliche Element jedes dieser zwei Motoren im Wesentlichen aus nichtmagnetischen Materialien gebildet ist.

5. X-Y-Tisch nach einem der vorhergehenden Ansprüche, **dadurch gekennzeichnet, dass** das bewegliche Element jedes der zwei Motoren mit mehreren nebeneinander angeordneten Flachspulen versehen ist, deren Wicklungsachsen zu der Ebene, die durch die zwei aktiven Richtungen (X, Y) definiert ist, senkrecht sind.

6. X-Y-Tisch nach einem der vorhergehenden Ansprüche, **dadurch gekennzeichnet, dass** für jeden der zwei Linearmotoren zwei Reihen von Permanentmagneten (12a, 12b) vorgesehen sind, die beiderseits des beweglichen Elements (6) angeordnet sind, derart, dass jedes Paar Permanentmagneten, die sich einander gegenüber befinden, zwei magnetische Achsen mit gleicher Richtung definiert.

7. X-Y-Tisch nach einem der vorhergehenden Ansprüche, **dadurch gekennzeichnet, dass** einer der zwei Linearmotoren durch zwei verschiedene Antriebseinheiten (C1, C2) gebildet ist, die sich beiderseits des beweglichen Schlittens (4) befinden.

## Claims

1. X-Y table associated with a load (CH; O, OS), such as a tool, and arranged for moving said load along two perpendicular active directions (X, Y), said table including:
- a base (1)
- a carriage (4) carrying said load (CH; O, OS) and mounted so as to move on the base along said two directions (X, Y); and
- two electric linear motors (B, C; B, C1, C2) arranged for driving said carriage respectively along said two active directions (X, Y), each of said two motors including a stator (5) and a moving part (6) provided with at least one excitation coil (20, 21) and mechanically coupled to said carriage, said moving part being capable of being moved along each of the two active directions (X, Y), said carriage being guided along said two active directions respectively by first and second slide means, a first (C) of the two motors moving a first moving mass moving along its active direction (Y) and the second (B) of said two motors moving a second moving mass along its active direction (X) comprising said first moving mass, **characterised in that** said first moving mass includes said load, said carriage and said moving parts of the two motors, said first moving mass forming a cohesive unit, **in that** the resulting force exerted by said first motor defines a first straight line which substantially intersects a vertical straight line passing through the centre of gravity (GY) of said first moving mass, said first straight line having a fixed position in relation to said first moving mass, **in that** the resulting force exerted by said second motor defines a second straight line which substantially intersects a vertical straight line passing through the centre of gravity (GX) of said second moving mass when said carriage is in a central position of the X-Y table along the active direction of said first motor, **in that** the two linear motors are arranged at the periphery of a main unit, formed by said carriage carrying said load and said first and second slide means, leaving at least one side of said carriage free, and **in that** each of the two linear motors has a plurality of juxtaposed permanent magnets (12a, 12b) of alternate north and south polarities along the active direction of said motor, said at least one excitation coil of either of the two motors having, along the active direction of the other of said two motors, a smaller dimension than the corresponding dimension of said permanent magnets of said motor, the difference between the two dimensions being substantially equal to or greater than the travel of the moving part of the motor concerned along the active direction of the other of said two motors.

2. X-Y table according to claim 1, **characterised in that** said second straight line substantially intersects said vertical line passing through the centre of gravity of said first moving mass.

3. X-Y table according to claim 1 or 2, **characterised in that** the respective moving parts of said first and second motors are arranged in a vertical position in relation to the first and second moving masses so that said first and second straight lines defined by the respective resulting forces of said first and second motors substantially intersect the centres of gravity of said first and second moving masses.

4. X-Y table according to any of the preceding claims, **characterised in that** said moving part of each of the two motors is essentially formed of non-magnetic material.

5. X-Y table according to any of the preceding claims, **characterised in that** the moving part of each of the two motors is provided with several flat juxtaposed coils whose winding axes are perpendicular to the plane defined by said two active directions (X, Y).

6. X-Y table according to any of the preceding claims, **characterised in that** for each of the two linear motors two series of permanent magnets (12a, 12b) are provided on either side of the moving part (6) such that each pair of permanent magnets located facing the other define two magnetic axes of the same direction.

7. X-Y table according to any of the preceding claims, **characterised in that** one of the two linear motors is formed by two distinct drive units (C1, C2) located on either side of the moving carriage (4).
